# EUROPEAN PATENT APPLICATION

(11) **EP 3 739 615 A1**
(43) Date of publication of application: **18.11.2020**
(21) Application number: 19174531.4
(22) Date of filing: 14.05.2019
(51) Int. Cl.: H01J 37/20, H01J 37/26

(54) **SAMPLE CARRIER FOR ELECTRON MICROSCOPY**

(71) Applicant: Universiteit Maastricht, 6211 LK Maastricht (NL)
(72) Inventor: Ravelli, Raimond, 6221 BW Maastricht (NL); Nijpels, Franciscus Johannes Theresia, 3620 Veldwezelt (BE); Peters, Jacobus Peter Johannes, 1072 BS Amsterdam (NL)
(74) Representative: De Vries & Metman

(57) **Abstract**

The invention relates to a sample carrier (1) for electron microscopy, in particular a sample carrier for imaging or diffraction experiments, e.g. under cryogenic conditions, comprising a support for a sample, e.g. an EM grid (2), and a rim (3) having a thickness greater than that of the support (2) for a sample. The support (2) for a sample and/or the rim (3) were formed and/or machined by means of laser ablation and/or laser welding.

## Description

The invention relates to a sample carrier for electron microscopy, in particular a sample carrier for imaging or diffraction experiments in an electron microscope, e.g. under cryogenic conditions, comprising a support for a sample, e.g. an electron microscopy grid (EM grid) or a film, e.g. in the form of a disc for high pressure freezing, and a rim having a thickness greater than that of the support for a sample, which rim e.g. provides sufficient stiffness and strength for the sample carrier to be handled, preferably automatically handled. The invention further relates to a method of making a sample carrier.

Sample carriers for electron microscopy are known. Current EM grids typically have an external diameter of 3.05 mm, are made of a metal, e.g. gold, titanium, copper, nickel, aluminum or molybdenum, and have a central mesh of, for example, square openings. The number of openings is referred to by a certain mesh number, which gives the number of lines per inch. E.g., a grid 300 mesh will have grid bars with a pitch of 83 µm, which are typically 25 µm wide, yielding an open square having a width of 58 µm. The thickness of the grid and grid bars is typically about 20 µm. The rim surrounding the central portion of squares is normally solid and has a width of 0.2 mm. For many applications, the grids are covered with a thin film. For example, in cryo-electron microscopy, a 10-12 nm thin perforated carbon film spans at least the center of the grid. The perforated film contains regularly spaced holes, with, e.g., having a diameter of 1.2 µm and a pitch of 2.5 µm.

US 4,250,127 discloses composite electron microscope grids for support of specimens and suitable for energy dispersive X-ray analysis. The grids are fabricated from an etched surfaced mold which is sacrificed after the grid casting.

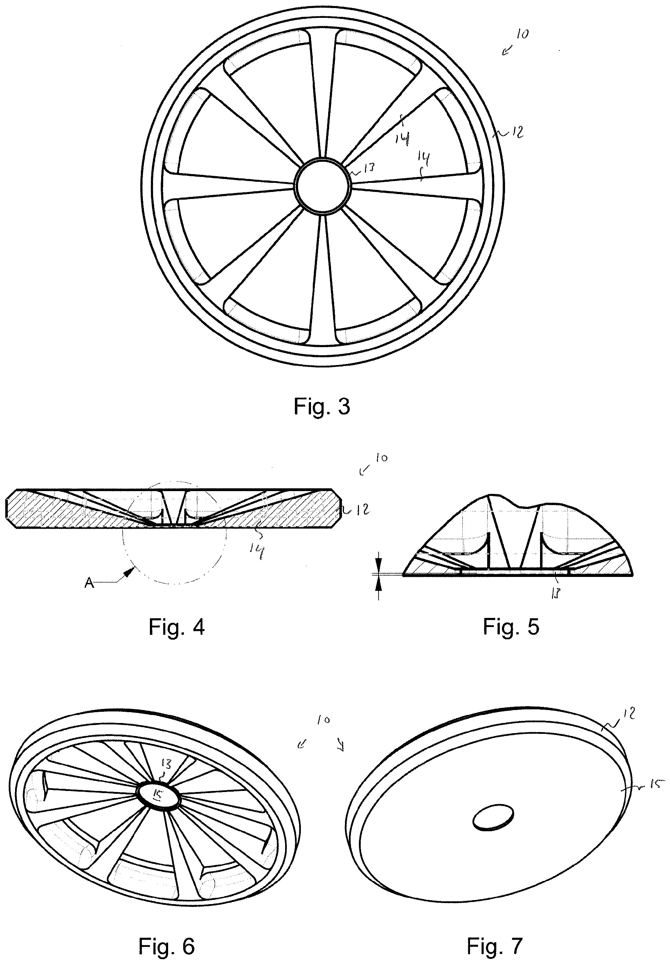

WO 2016/008502 illustrates, in Figures 4A to 4C of that publication, examples of identification features of a grid, wherein the identification features comprise grid labels, which are formed as through-holes in a circumferential portion of the grid and/or as a dot code (see Figure 4B). The identification features allow a traceability of grids and grid recognition inside or outside the microscope.

EP 1 489 642 A1 discloses a sample carrier for a sample to be irradiated with an electron beam, the sample carrier comprising a middle portion that is at least partially transparent to electrons, and an edge portion, located at the periphery of the middle portion, wherein at least a portion of the periphery of the middle portion has a thickness that is greater than the thickness of the middle portion. An advantage of a thicker edge portion is that it becomes possible to grab hold of the external periphery of the edge portion using manipulation means such as pincers or an automatic introduction mechanism. By having the manipulation means grab hold of the external periphery of the edge portion, said means cannot damage the sample attached to the middle portion of the sample carrier. EP 1 489 642 A1 does not disclose specifics of the configuration of the sample carrier or how the sample carrier is made.

Currently, 3D sample carriers are obtained by post-mounting an essentially 2D sample carrier, e.g. an EM grid, carrying a (vitrified) sample into a cartridge. Nota bene: the 3D sample carrier is assembled after the sample has been applied to the 2D sample carrier. The cartridge is essentially a ring configured to accommodate an EM grid. The EM grid with sample is carefully positioned in the cartridge and subsequently fixed in position using a C-clip ring. This assembly is performed manually under cryogenic conditions and, consequently, is accompanied by all kinds of undesired side effects, such as bending of the grid, (extensive) damage to the fragile thin support layer on the grid, or a twist in the C-clip ring resulting in poor thermal contact between grid and cartridge. Manual mounting is intrinsically poorly reproducible. Post-assembly is necessary because current commercial vitrification devices are unable to properly vitrify the increased mass of a pre-assembled 3D sample carrier.

Further, currently, sample carriers are stored in storage containers. Logbooks are used to keep track of which sample is stored in which position of which storage container. Samples are manually transferred in a defined order into the electron microscope, e.g. by loading them in a cassette that contains multiple carriers. The information of which sample is applied onto which sample carrier is thus transferred between one or multiple persons before arriving at the operator of the electron microscope. All information transfer steps are done by humans and are susceptible to errors.

It is an object of the present invention to provide an improved sample carrier for imaging or diffraction experiments in an electron microscope. Such imaging or experiments may be performed e.g. under cryogenic conditions.

To this end, the sample carrier according to the present invention is characterized in that the support for a sample and/or the rim were treated and/or machined, e.g. customized, by means of laser ablation and/or laser welding. In an embodiment, the support for a sample and/or the rim were formed and/or machined by removing material with a pulsed laser, preferably a femto-seconds or pico-seconds laser.

In another embodiment, and depending on the material of the support, the laser is an infrared laser, i.e. a laser operating at a wavelength equal to or in excess of 700 nm. For titanium, infrared lasers are preferred.

In another embodiment, if the material of the support is a highly reflective material, such as copper or gold, the laser is a green laser, i.e. a laser operating at a wavelength in a range from 505 to 560 nm, e.g. in a range from 510 to 525 nm, e.g. 515 nm.

In another embodiment, the power of the laser is in a range from 1 to 180 Watt. A power up to 180 Watt is used to ablate thicker layers of material, whereas a power of 10 to 20 Watt or less is used to form or machine smaller of thinner parts of the assembly (e.g. having a thickness of 20 µm).

In another embodiment, the grid is laser welded to the rim, e.g. by means of a continuous wave (CW) laser having a power in a range from 500 to 1000 Watt and a spot diameter in a range from 2 to 40 µm, e.g. 20 µm. In another embodiment, the laser is a milliseconds pulsed laser.

It was found that laser ablation and/or laser welding are effective means to manufacture large numbers of sample carriers at a controlled and substantially constant quality and that require less or no assembly. The use of a laser in the production process also allows for the introduction of detailed features that facilitate e.g. application of a sample to the sample carrier and/or identification of the sample carrier, which are advantages of great significance for certain kinds of sample application procedures or when samples are processed in large numbers and/or at different locations.

The invention also relates to a sample carrier for electron microscopy, in particular a sample carrier for imaging or diffraction experiments in an electron microscope, e.g. under cryogenic conditions, comprising a support for a sample, e.g. an EM grid, and a rim having a thickness greater than that of the grid, which rim provides stiffness and strength for the sample carrier to be handled, preferably automatically handled, and wherein i) the support for a sample is permanently fixed, e.g. welded, to the rim or ii) the support for a sample and the rim are formed from the same piece of material, such as a blanc, e.g. a metal disc, thus yielding a unitary sample carrier.

In an embodiment, the sample carrier is still pristine, i.e. not carrying a sample. In an embodiment, at least the support for a sample and preferably also the rim is (are) biocompatible, i.e. compatible with living tissue or a living system by not being toxic, detrimental, or physiologically reactive, and preferably made of bioinert metals such as titanium, gold or platinum, or of bio-tolerant metals such as tantalum, niobium, molybdenum or alloys such as cobalt-chromium.

In an embodiment, the support for a sample comprises one or more cavities and/or one or more channels, e.g. capillary channels to wick a volume, e.g. excess volume, of a liquid sample when it is deposited on the grid, either directly on the support, e.g. a grid, or on a further substrate, such as a perforated film, present on the support. In an example, the support for a sample comprises at least one capillary channel which fluidly communicates with a cavity and which thus serves as a reservoir for receiving wicked liquid or, alternatively, as a supply.

Generally, the volumes used to apply e.g. single particle samples onto a grid are in excess of what is needed to obtain the desired thin sample layer. Existing grids already have some wicking properties. However, these are insufficient to remove the excess of sample normally applied to the grid and an additional step, such as blotting, or measures, such as nanowires, are needed to remove excess sample. Both result in loss of sample and, further, nanowire grids are produced chemically and consists of fragile crystalline wires attached to the grid bars. The shape and form of these wires are poorly reproducible and they are fragile and prone to breaking off, polluting the electron microscopy.

It was found that laser ablation, e.g. by means of a femto-seconds laser, inherently provides a relatively hydrophilic surface and is an effective means to provide improved wicking properties on the sample carrier itself.

In an embodiment, the sample carrier is provided with at least one identifier, enabling tracking of the sample at different locations and/or instruments.

Worldwide, there are more labs interested in having their samples examined than there are labs with mid-range and/or high-end electron microscopes. Some facilities provide microscope time for users that ship their samples to these facilities. Providing an identifier directly on the sample carrier enables effective and efficient tracking and logging of samples and data obtained from the samples.

It is preferred that the identifier is distinguishable (readable) both by means of visible light (400 to 700 nm) and by means of an electron beam. The invention also relates to a plurality of sample carriers, e.g. a set of sample carriers in a container, such as a dewar or cassette, wherein each sample carrier in the set is provided with a unique identifier.

Currently, high pressure freezers (HPFs), such as the Leica EM PACT2, the Leica ICE, or the Baltec HPM-010 High Pressure Freezer, use specimen carriers unsuitable for direct use within a cryo-EM, while the existing 2D cryo-EM sample carriers are too fragile for HPFs. With the present invention, it is possible to manufacture 3D carriers that are both compatible with HPFs and suitable for electron microscopy. To this end, in an embodiment, the support for a sample comprises at least a circumferential wall and a (bottom) film forming a reservoir for a sample that is to be vitrified by means of a high pressure freezer. In a refinement, the circumferential wall is located in the center of the sample carrier and preferably connected to the rim of the sample carrier by means of spokes.

In an embodiment, the support for a sample has a thickness in a range from 5 to 200 µm, preferably in a range from 10 to 40 µm, e.g. 20 µm, and the rim has a thickness in a range from 100 µm to 1 mm, preferably in a range from 150 µm to 0,7 mm and a diameter in a range from 2 to 5 mm, preferably 2,5 to 4 mm.

In an embodiment, one or more of the cavities, channels, circumferential walls and/or identifiers has respectively have been applied by means of laser ablation and/or laser welding.

The invention further relates to a method of manufacturing a sample carrier for electron microscopy, in particular a sample carrier for imaging or diffraction experiments in an electron microscope, e.g. under cryogenic conditions, and comprising a support for a sample and a rim having a thickness greater than that of the support for a sample, characterized by forming and/or machining the support for a sample and/or the rim by means of laser ablation and/or laser welding, preferably with a pulsed laser, preferably a femto-seconds or pico-seconds laser.

The invention further relates to a method of manufacturing a sample carrier comprising the steps of positioning the support for a sample in the rim and permanently fixing, e.g. welding, the support for a sample to the rim or comprising the step of forming the support for a sample and the rim from the same piece of material, such as a blanc, e.g. a metal disc.

An embodiment comprises the step of machining by means of laser ablation, in the support for a sample, one or more cavities, channels, circumferential walls and/or identifiers, described above.

In an embodiment, a sample is prepared for imaging or diffraction experiments in an electron microscope, e.g. under cryogenic conditions, by applying a sample to a sample carrier according to the present invention and vitrifying the sample by directing a jet of liquid coolant to the center of the carrier and onto the sample, preferably by directing at least one jet of liquid coolant to each side of the carrier. Thus, the sample is vitrified first in the center of the support and from there towards the edge of the support, reducing or excluding effects of features, such as reinforcement of the support, located on that edge. More specifically, the present method enables extreme cooling rates in the sample itself, e.g. cooling rates in excess of 50.000 K/s, despite the presence of such features, that contain a relatively large amount of heat and thus slow down cooling. Suitable liquid coolants include ethane, ethane-propane, helium, and nitrogen. Coolants preferably have a temperature in a range from 4 to 120 K. For further details on this type of vitrification, reference is made to WO 2017/220750. For thicker samples, the jets can be applied within a high-pressure chamber, where one side of the sample is closed of by a thin film, having a thickness in a range from 0.02 to 2 µm, preferably in a range from 20 to 200 nm, e.g. 50 nm, whereas the other side of the sample is closed off by a lid that can be removed after sample vitrification.

Within the framework of the present invention, the words "permanently fixed" are defined as attached such that the parts are stationary relative to each other and that it is clear that the attached parts should remain attached and that separating the parts will result in damage, such as fracture(s) and/or plastic deformation. Examples of permanently fixing include welding, (heat) swaging, soldering, and gluing.

The invention will now be explained in more detail with reference to the Figures, which show an embodiment of the present invention.
Figure 1 is a top view of a sample carrier according to the present invention comprising an EM grid.
Figure 2 is cross-section of a part of the sample carrier shown in Figure 1.
Figure 3 is a top view of a further sample carrier according to the present invention suitable for high pressure freezing.
Figures 4 and 5 are a cross-section and a detail of that cross-section of the sample carrier shown in Figure 3
Figures 6 and 7 are perspective views of the sample carrier shown in Figure 3.
Figure 8 is a top view of yet a further sample carrier according to the present invention comprising wicking channels.
Figure 9 is a cross-section of the sample carrier shown in Figure 8.
Figures 10 and 11 are enlarged details of the sample carrier shown in Figure 8.
Figure 12 is a top view of a further sample carrier according to the present invention comprising at least one identifier.

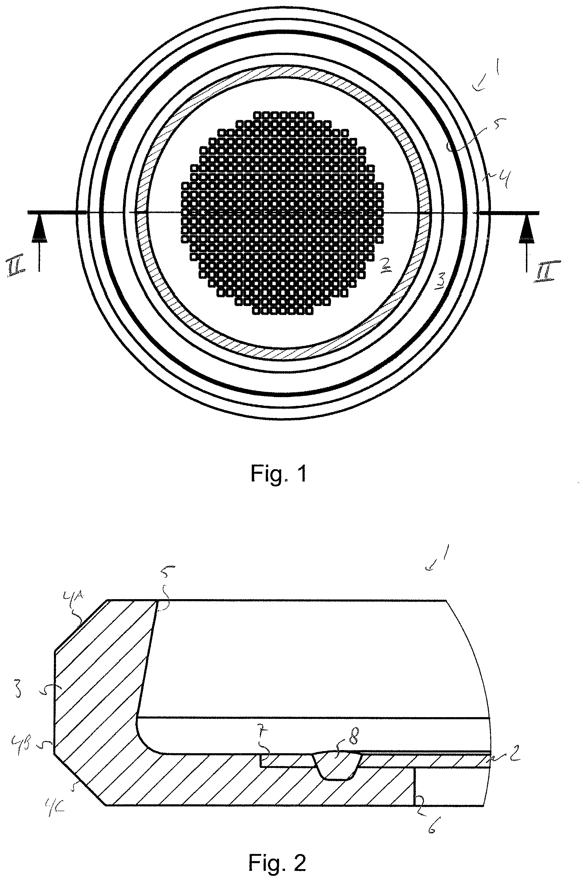

Figures 1 and 2 show a sample carrier 1 for imaging in an electron microscope, e.g. under cryogenic conditions, comprising a support for a sample, in this case a standard EM grid 2, and a rim 3 having a thickness greater than that of the EM grid and formed by means of a femto-seconds laser.

The outer contours 4A, 4B, 4C of the rim 3 are configured to enable automatic handling of the sample carrier during application of a sample, vitrification of the sample, storage and imaging in an electron microscope. The rim is effectively a ring with a upper opening 5 having a diameter larger than that of the EM grid and a bottom opening 6 having a diameter smaller than that of the EM grid 2. A annular recess 7 was machined, by means of the femto-seconds laser, along the bottom opening, which recess has a diameter and height corresponding to those of the EM grid. As shown in Figure 2, the EM grid is positioned in the recess and permanently fixed to the rim e.g. by means of an annular weld 8 or a ring of welding spots.

In an alternative example, the EM-grid is fixed inside the rom by means of a C-clip or a horseshoe-clip also made by means of a femto-seconds laser. Such a clip can be made almost perfectly flat, avoiding or at least reducing, compared to exaiting C-clips, tension and/or deformation in the sample carrier and in particular the fragile grid.

Figures 3 to 7 show a unitary sample carrier 10 comprising a rim 12 and a central ring 13 held in the rim 12 by spokes 14. The ring forms a circumferential wall of a sample reservoir. A metal disc 15, having a central opening that is aligned with the ring 13, is fixed to the bottomside of the carrier 10. A thin film (not shown) is positioned over and attached to the metal disc 15, thus forming the bottom wall or layer of the sample reservoir. The reservoir can be closed off on its other side, e.g. with a diamond placed on disc 15, such that a sample contained in the reservoir can be vitrified by means of high-pressure freezing. Alternatively, the thin sample reservoir is left open and vitrified by jet vitrification.

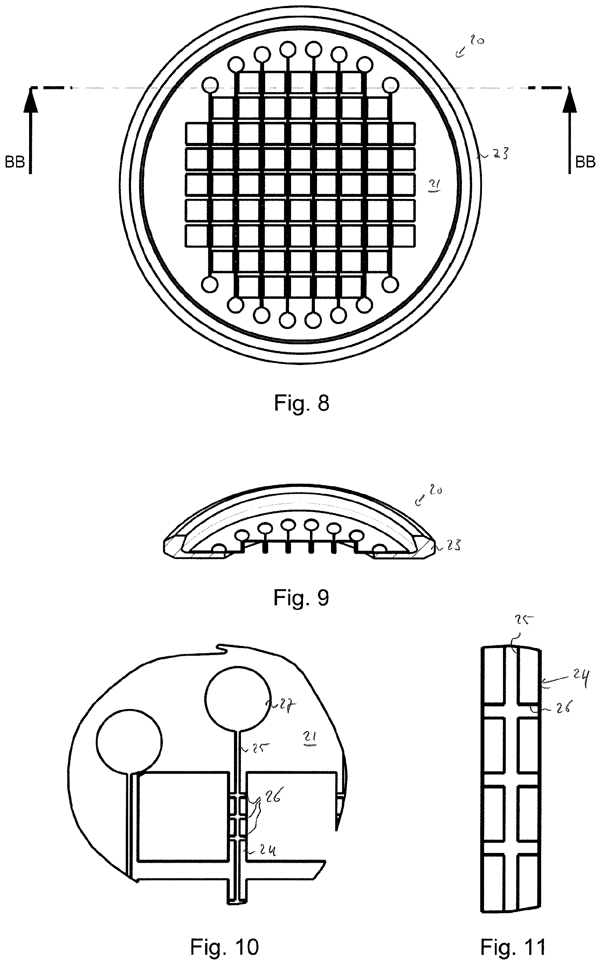

Figures 8 to 11 show a sample carrier 20 comprising a support, essentially an EM grid 21, for a sample formed by means of a femto-seconds laser, and positioned, e.g. by means of welding, inside a standard cartridge 23.

The support 21 for a sample comprises on each of the bars 24 of the grid, a main capillary or wicking channel 25 running the length of the bar and a plurality of cross-channels 26 spanning the width of the bar. Each main channel communicates on either end with a cavity, in this case a circular cavity 27, which serves as a reservoir for excess liquid wicked from a sample apply to the grid of, if present, a film attached over the grid.

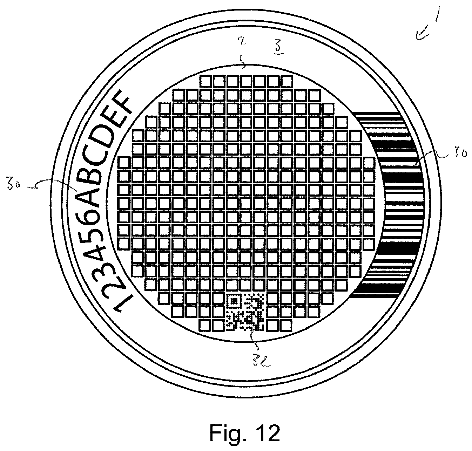

Figure 12 shows a sample carrier 1 illustrating suitable examples and positions for an identifier, such as a barcode 30 or number 31 defined in the rim 3 of the sample carrier or a QR-code 32 defined in the EM grid 2, e.g. in the form of small cavity or small through-holes. The use of an identifier enables tracking of the sample at different locations and/or in different instruments.

The invention is not restricted to the above-described embodiments, which can be varied in a number of ways within the scope of the claims.

## Claims

1. Sample carrier (1) for electron microscopy, in particular a sample carrier for imaging or diffraction experiments, comprising a support (2) for a sample and a rim (3) having a thickness greater than that of the support (2) for a sample, **characterized in that** the support (2) for a sample and/or the rim (3) were formed and/or machined by means of laser ablation and/or laser welding.

2. Sample carrier (1) according to claim 1, wherein the support (2) for a sample and/or the rim (3) were formed and/or machined by removing material with a pulsed laser, preferably a femto-seconds or pico-seconds laser.

3. Sample carrier (1) according to claim 1 or 2, wherein the support (2) for a sample and/or the rim (3) were formed and/or machined by an infrared laser or a green laser, and/or by a laser having a power in a range from 1 to 180 Watt, and/or by a continuous wave (CW) laser having a power in a range from 500 to 1000 Watt and/or a spot diameter in a range from 5 to 40 µm.

4. Sample carrier (1) according to any one of the preceding claims or the pre-amble of claim 1, wherein the support (2) for a sample is permanently fixed to the rim (3) or the support (2) for a sample and the rim (3) are formed from the same piece of material.

5. Sample carrier (1) according to any one of the preceding claims, wherein the support (2) for a sample is biocompatible and preferably the entire carrier (1) is biocompatible.

6. Sample carrier (1) according to any one of the preceding claims, wherein the support (2) for a sample comprises one or more cavities (27) and/or one or more channels, preferably at least one capillary channel (25, 26) which fluidly communicates with a cavity (27).

7. Sample carrier (1) according to any one of the preceding claims, wherein the sample carrier (1) is provided with at least one identifier (30, 31, 32), preferably an identifier that is distinguishable both by means of visible light and by an electron beam.

8. Sample carrier (1) according to any one of the preceding claims, wherein the support (2) for a sample comprises at least a circumferential wall (13) and a (bottom) film forming a reservoir for a sample that is to be vitrified by means of a high pressure freezer and/or jet vitrification.

9. Sample carrier (1) according to any one of the preceding claims, wherein one or more cavities (27), channels (25, 26), circumferential walls (13) and/or identifiers (30, 31, 32) has respectively have been applied by means of laser ablation.

10. Sample carrier (1) according to any one of the preceding claims, wherein the support (2) for a sample has a thickness in a range from 5 to 100 µm, preferably in a range from 10 to 40 µm, and the rim (3) has a thickness in a range from 100 µm to 1 mm, preferably in a range from 150 µm to 0,7 mm, and a diameter in a range from 2 to 5 mm, preferably 2,5 to 4 mm.

11. Method of manufacturing a sample carrier (1) for electron microscopy, in particular a sample carrier for imaging or diffraction experiments, and comprising a support (2) for a sample and a rim (3) having a thickness greater than that of the support (2) for a sample, **characterized by** forming and/or machining the support (2) for a sample and/or the rim (3) by means of laser ablation, preferably with a pulsed laser, preferably a femto-seconds or pico-seconds laser, and/or laser welding.

12. Method according to claim 11, wherein the support (2) for a sample and/or the rim (3) is formed and/or machined by an infrared laser or a green laser, and/or by a laser having a power in a range from 1 to 180 Watt, and/or by a continuous wave (CW) laser having a power in a range from 500 to 1000 Watt and/or a spot diameter in a range from 5 to 40 µm.

13. Method according to claim 11 or 12 or the preamble of claim 11, comprising the steps of
positioning the support (2) for a sample in the rim (3) and permanently fixing or clamping the support (2) for a sample to the rim (3) or
the step of forming the support (2) for a sample and the rim (3) from the same piece of material.

14. Method according to any one of claims 11-13, comprising the step of machining by means of laser ablation, in the support (2) for a sample and/or the rim (3) one or more cavities (27), channels (25, 26), circumferential walls (13) and/or identifiers (30, 31, 32).

15. Method of preparing a sample for imaging or diffraction experiments by applying a sample to a sample carrier (1) according to any one of the claims 1-10 and vitrifying the sample by directing a jet of liquid coolant to the center of the carrier (1) and onto the sample, preferably by directing at least one jet of liquid coolant to each side of the carrier (1).
